# FASCICULE DE BREVET EUROPEEN

(11) **EP 2 165 005 B1**
(45) Date de publication et mention de la délivrance du brevet: **21.05.2014**
(21) Numéro de dépôt: 08806162.7
(22) Date de dépôt: 03.07.2008
(51) Int. Cl.: C23C 16/40, C23C 16/30, C23C 16/04, C23C 16/02, B05D 7/24

(54) **REVETEMENT BARRIERE DEPOSE PAR PLASMA COMPRENANT AU MOINS TROIS COUCHES, PROCEDE D'OBTENTION D'UN TEL REVETEMENT ET RECIPIENT REVETU D'UN TEL REVETEMENT**
PLASMAABGELAGERTE SPERRBESCHICHTUNG MIT MINDESTENS DREI SCHICHTEN, VERFAHREN ZUR HERSTELLUNG EINER SOLCHEN BESCHICHTUNG UND DAMIT BESCHICHTETER BEHÄLTER
PLASMA-DEPOSITED BARRIER COATING INCLUDING AT LEAST THREE LAYERS, METHOD FOR OBTAINING ONE SUCH COATING AND CONTAINER COATED WITH SAME

(30) Priorité: 06.07.2007 FR 0704899
(43) Date de publication de la demande: 24.03.2010
(73) Titulaire: Sidel Participations, 76930 Octeville Sur Mer (FR)
(72) Inventeur: BOUTROY, Naïma, F-76930 Octeville-sur-Mer (FR); BELDI,Nasser, F-76930 Octeville-sur-Mer (FR)
(74) Mandataire: Cabinet Plasseraud
(86) Numéro de dépôt international: PCT/FR2008/051239
(87) Numéro de publication internationale: WO 2009/007654

(56) Documents cités:
- EP-A- 1 630 250
- WO-A-01/94448
- WO-A-02/09891

## Description

La présente invention a pour domaine d'application les revêtements barrières en couche mince déposés par mise en oeuvre d'un plasma à faible pression, c'est-à-dire à une pression inférieure à la pression atmosphérique, et plus précisément à une pression de l'ordre de 5x10⁻⁴ bar. De manière courante, de tels revêtements sont obtenus en injectant un fluide réactionnel, en général à l'état gazeux, sous faible pression dans une zone de traitement. Un champ électromagnétique est formé dans la zone de traitement afin de porter ce fluide à l'état de plasma, c'est-à-dire pour en provoquer une ionisation au moins partielle. Les particules issues de cette ionisation peuvent alors se déposer sur les parois de l'objet placé dans la zone de traitement.

Les dépôts par plasmas à basse pression, ou plasmas froids, permettent de déposer des couches minces sur des objets en matière plastique, par exemple des films ou des récipients, notamment dans le but de diminuer la perméabilité aux gaz, tels que l'oxygène et le dioxyde de carbone.

Il est ainsi possible d'utiliser une telle technologie pour revêtir d'un matériau barrière les bouteilles en plastique, notamment en matière thermoplastique, destinées à conditionner des produits sensibles à l'oxygène, tels que la bière ou les jus de fruits, ou des produits carbonatés tels que les sodas.

Un dispositif permettant de recouvrir la face interne ou externe d'une bouteille en plastique avec un revêtement barrière est par exemple décrit dans le document WO99/49991.

Il est ainsi connu du document FR 2 812 568 au nom de la Demanderesse un procédé mettant en oeuvre un plasma à basse pression pour déposer un revêtement barrière sur un substrat à traiter, du type dans lequel le plasma est obtenu par ionisation partielle, sous l'action d'un champ électromagnétique, d'un fluide réactionnel injecté sous faible pression dans une zone de traitement, le procédé comportant au moins une étape consistant à déposer sur le substrat une couche d'interface qui est obtenue en portant à l'état de plasma un mélange comportant au moins un composé organosilicé et un composé azoté, et une étape consistant à déposer, sur la couche d'interface, une couche barrière, composée essentiellement d'un oxyde de silicium de formule SiOx.

Toutefois, même si le revêtement barrière obtenu selon le procédé décrit dans le document FR 2 812 568 est satisfaisant, il serait particulièrement intéressant d'améliorer les propriétés barrières du récipient en plastique obtenu pour ainsi augmenter le temps de conservation des boissons conditionnées dans ces récipients tout en conservant leurs qualités nutritives.

Egalement, il est connu d'après le document EP 1 630 250 A1 un procédé mettant en oeuvre un plasma à faible pression pour déposer un revêtement barrière vis-à-vis des gaz sur un substrat thermoplastique, dans lequel le plasma est obtenu par ionisation partielle, sous l'action d'un champ électromagnétique, d'un fluide réactionnel injecté sous faible pression dans une zone de traitement.

Sur la surface d'un substrat tel qu'un substrat en matière thermoplastique est formée, par une étape de pré-évaporation sous vide, une première couche d'un polymère organosilicé qui est flexible et qui adhère au substrat (couche d'adhésion ou couche d'interface). Puis, sur cette couche d'adhésion est formée une deuxième couche en oxyde de silicium SiOx, par une étape d'évaporation sous vide principale, qui possède des propriétés de barrière au gaz. Enfin, par une étape de post-évaporation sous vide, on forme une troisième couche, externe, sur la couche d'oxyde de silicium, cette troisième couche ayant une composition proche de celle de la susdite deuxième couche et possédant des propriétés hydrophobes améliorant les propriétés barrière contre la vapeur d'eau.

Selon ce procédé connu, le dépôt des trois couches est effectué en continu en alimentant dans la chambre de réaction au moins un composé organométallique, notamment organosilicé, avec un débit constant et un gaz oxydant (qui peut être l'oxygène) avec un débit modifié dans le temps en relation avec les caractéristiques de la couche à former, de sorte que la composition (Si, O, C) du revêtement varie selon les couches.

Un revêtement constitué selon ce document présente une fonction de barrière aux gaz, notamment l'oxygène et le dioxyde de carbone, qui est conférée par la deuxième couche supportée par la première couche d'adhésion, tandis qu'elle présente également une fonction de barrière à la vapeur d'eau qui est conférée par la troisième couche externe.

Cependant, la fonction de barrière aux gaz n'est pas affectée par la présence de la troisième couche externe, et plus spécifiquement, la fonction de barrière aux gaz n'est pas améliorée ou augmentée en efficacité en raison de la présence de la troisième couche externe.

On connait certes également, d'après le document FR 2 812 568 déjà cité plus haut, un revêtement à effet barrière aux gaz constitué de trois couches, dont une première couche d'adhésion et une seconde couche en silice SiOx comme exposé plus haut. Toutefois, la troisième couche, externe, est constituée en carbone amorphe hydrogéné déposé par plasma basse pression avec une épaisseur trop faible pour que cette troisième couche puisse présenter un quelconque effet barrière : il s'agit donc uniquement d'une couche de protection, permettant de réduire la dégradation des propriétés barrière du revêtement en présence de déformations, et l'effet barrière est uniquement conféré par la deuxième couche.

Enfin, le document WO 01/94448 A1 décrit un revêtement à effet barrière formé, par mise en oeuvre d'un plasma, sur un substrat thermoplastique tel que le PET, lequel revêtement comprend une première couche de formulation SiOxCyHz qui est déposée au contact du substrat en tant que sous-couche pour une deuxième couche en SiOx présentant un effet barrière ; une couche additionnelle est formée sur la deuxième couche (exemples 1 et 2 dudit document) ; le processus se déroule en traitant un composé organosilicé TMDSO d'abord seul, pour former la première couche, puis avec un apport d'oxygène et avec un réglage approprié des débits de TMDSO et d'oxygène pour former la deuxième couche, puis la troisième couche ; on obtient un revêtement clair et non coloré. L'exemple 8a de ce document expose un processus de formation continu des trois couches, en maintenant un débit constant de TMDS et en modifiant le débit d'oxygène (débit nul pour la première couche, débit donné pour la deuxième couche, débit décuplé pour la troisième couche) et en adaptant la durée d'application de la puissance microondes (2 secondes pour la première couche, 5 secondes pour la deuxième couche, 4 secondes pour la troisième couche) ; le revêtement obtenu, clair et non coloré, présente des propriétés barrière analogues à celles obtenues à l'exemple 2. Le procédé connu d'après ce document est conduit en particulier par réglage du débit d'oxygène, et le but clairement établi est la recherche d'un revêtement clair et non coloré, ne modifiant pas la couleur du substrat, et non pas une amélioration de l'effet barrière.

Face à l'état de la technique qui vient d'être exposé, deux aspirations, qui peuvent paraitre au moins en partie a priori inconciliables, voire antagonistes, se font jour. D'une part, les conditionneurs de liquides sensibles souhaitent pouvoir disposer de récipients en matière thermoplastique qui présentent des caractéristiques barrière améliorées permettant de conserver lesdits liquides sensibles plus longtemps avec une moindre perte de leurs qualités. Certes un tel but pourrait être atteint avec des revêtements à effet barrière qui soient renforcés avec des couches barrière plus épaisses et/ou plus nombreuses (couches multiples). Par ailleurs, toujours à la demande des conditionneurs, il est souhaitable de simplifier et d'accélérer, autant que faire se peut, le processus de dépôt du revêtement barrière afin de réduire le prix de revient et d'accélérer les cadences de fabrication : ces buts particuliers sont totalement incompatibles avec la mise en oeuvre de couches plus épaisses et/ou plus nombreuses.

Il serait également particulièrement intéressant, par rapport aux procédés selon l'art antérieur, de réaliser un procédé de dépôt par plasma de couches barrières internes qui serait facile à mettre en oeuvre d'un point de vue industriel en ne nécessitant pas un réglage trop précis.

C'est dans ce contexte que l'invention propose des moyens (procédé et revêtement) qui permettent de donner satisfaction aux deux requêtes précitées a priori inconciliables.

Pour ce faire, selon un premier de ses aspects, la présente invention porte sur un procédé mettant en oeuvre un plasma à faible pression pour déposer un revêtement barrière vis-à-vis des gaz sur un substrat thermoplastique, dans lequel le plasma est obtenu par ionisation partielle, sous l'action d'un champ électromagnétique, d'un fluide réactionnel injecté sous faible pression dans une zone de traitement, ce procédé comportant :
- au moins une première étape consistant à déposer, sur le substrat thermoplastique, une première couche, ou couche d'adhésion, qui est obtenue en portant à l'état de plasma un mélange comprenant au moins un composé organosilicé et un autre composé,
- au moins une deuxième étape consistant à déposer, sur ladite première couche, une deuxième couche, ou couche à effet barrière, qui est obtenue en portant à l'état de plasma un composé conduisant essentiellement à un oxyde de silicium de formule SiOx, laquelle deuxième couche présente un effet barrière vis-à-vis des gaz, et
- au moins une troisième étape consistant à déposer, sur ladite deuxième couche, une troisième couche qui est obtenue en portant à l'état de plasma un mélange comprenant au moins un composé organosilicé et un autre composé,
- les mélanges utilisés pour la formation des première et troisième couches étant de compositions au moins relativement proches,
caractérisé en ce que lesdits autres composés sont tous deux des composés azotés.

Certes, l'azote est déjà présent dans les réactions menées conformément aux procédés connus d'après les documents précités. Toutefois, l'azote est alors utilisé comme gaz vecteur (gaz neutre dans le cadre de ces procédés) et/ou il est présent dans un composé du type NOx qui est utilisé comme oxydant. Dans tous les cas, les réactions sont conduites avec un oxydant (soit l'oxygène gazeux, soit l'oxygène libéré par un composé oxydant tel que NOx) : du fait de sa très forte réactivité, seul l'oxygène intervient effectivement dans les réactions exposées dans les documents précités, tandis que l'azote, du fait de son activité moindre, ne réagit pas et n'est pas présent dans les compositions des couches formées. Ainsi, les première et troisième couches des revêtements antérieurs répondent à la formule SiOx'Cy'Hz', alors que les premières et troisièmes couches du revêtement conforme à l'invention répond à la formule SiOxCyHzNu, dans laquelle x, y, z et u peuvent avoir les valeurs indiquées plus loin.

C'est avec surprise que la Déposante a alors pu constater que, bien que les première et troisième couches ne présentent individuellement aucun effet barrière vis-à-vis des gaz, l'ensemble des première, deuxième et troisième couches présente un effet barrière vis-à-vis des gaz qui est supérieur à celui procuré par les seules première et deuxième couches.

Dans un mode de mise en oeuvre préféré, lesdits mélanges utilisés pour la formation des première et troisième couches respectivement sont de compositions identiques et comprennent le même composé azoté.

Dans un exemple de mise en oeuvre simple et donc préféré, le composé azoté est de l'azote gazeux.

Avantageusement, l'étape consistant à déposer une deuxième couche composée essentiellement d'un oxyde de silicium de formule SiOx est obtenue en portant à l'état de plasma un mélange comportant au moins un composé organosilicé, un composé azoté et de l'oxygène.

De manière avantageuse, le composé organosilicé est un organosiloxane, préférentiellement de l'hexaméthyldisiloxane, du triméthydisiloxane ou du triméthylsilane.

De manière avantageuse, afin de réduire le temps total pour la mise en oeuvre du procédé selon l'invention, les étapes s'enchaînent en continu de telle sorte que, dans la zone de traitement, le fluide réactionnel demeure à l'état de plasma lors des transitions des différentes étapes.

Avantageusement, pour une zone de traitement présentant un volume de 500 mL, le débit d'injection de l'hexaméthyldisiloxane est compris entre 4 et 12 sccm, et est préférentiellement de 5 sccm, le débit d'injection de l'azote gazeux est compris entre 10 et 100 sccm, et est préférentiellement de 30 sccm, le débit d'injection du dioxygène est compris entre 40 et 120 sccm, la puissance microondes appliquée est comprise entre 200 et 500 W, et est préférentiellement de 350 W.

Afin de permettre une cadence de production la plus élevée possible, le temps de dépôt de la première couche est compris entre 0,2 et 2 secondes, en ce que le temps de dépôt de la deuxième couche est compris entre 1 et 4 secondes et en ce que le temps de dépôt de la troisième couche est compris entre 0,2 et 2 secondes, le temps total du procédé étant compris entre 2,4 et 4 secondes.

Selon un second de ses aspects, la présente invention porte également sur un revêtement barrière déposé sur un substrat thermoplastique par plasma à basse pression, comportant :
- une première couche, ou couche d'adhésion, déposée sur le substrat, constituée d'un composé comprenant au moins du silicium, du carbone, de l'oxygène et de l'hydrogène,
- une deuxième couche, ou couche à effet barrière, déposée sur ladite première couche, composée essentiellement d'un oxyde de silicium de formule SiOx, et
- une troisième couche déposée sur ladite deuxième couche, constituée d'un composé comprenant au moins du silicium, du carbone, de l'oxygène et de l'hydrogène,
- les première et troisième couches ayant des compositions chimiques sensiblement voisines,
caractérisé en ce que lesdits composés constitutifs desdites première et troisième couches comprennent tous deux en outre de l'azote,
ce grâce à quoi, bien que les première et troisième couches ne présentent individuellement aucun effet barrière vis-à-vis des gaz, l'ensemble des première, deuxième et troisième couches présente un effet barrière vis-à-vis des gaz qui est supérieur à celui procuré par les seules première et deuxième couches.

De manière avantageuse, l'épaisseur des première et troisième couches est inférieure à 20 nm, et de manière préférentielle est d'environ 4 nm.

Avantageusement, la première couche et la troisième couche ont sensiblement la même composition chimique.

Selon une forme de réalisation avantageuse du revêtement selon l'invention, la deuxième couche est composé essentiellement d'un oxyde de silicium de formule SiOx avec x compris entre 1,8 et 2,1.

De manière avantageuse, la première couche et/ou la troisième couche présentent une composition chimique de formule SiOxCyHzNu, la valeur de x étant comprise entre 1 et 1,5, et préférentiellement de 1,25, la valeur de y étant comprise entre 0,5 et 2, et est préférentiellement de 1,5, la valeur de z étant comprise entre 0,5 et 2, et est préférentiellement de 0,85, et la valeur de u étant comprise entre 0,1 et 1, et est préférentiellement de 0,5.

De manière supplémentaire, le revêtement selon l'invention comprend une quatrième couche, déposée sur la troisième couche, composée essentiellement d'un oxyde de silicium de formule SiOx ainsi qu'une cinquième couche, déposée sur la quatrième couche, composée essentiellement de silicium, de carbone, d'oxygène, d'azote et d'hydrogène.

Selon un troisième de ses aspects, la présente invention porte également sur un récipient en matière polymère, caractérisé en ce qu'il est recouvert, sur au moins une de ses faces, d'un revêtement barrière tel que précédemment indiqué.

Avantageusement, le récipient est revêtu d'un revêtement barrière sur sa face interne.

De manière avantageuse, le récipient est une bouteille en polyéthylène téréphtalate.

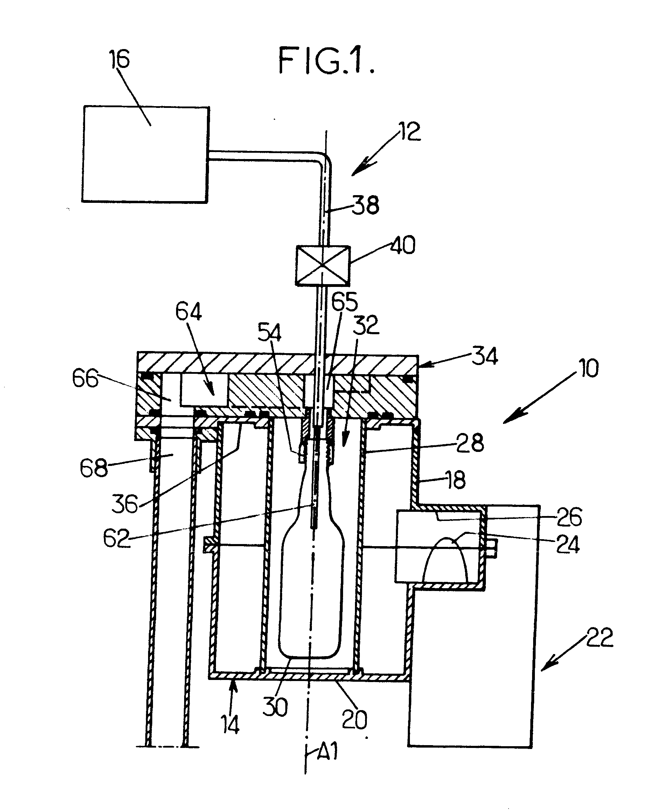

La présente invention va maintenant être décrite à l'aide d'un exemple uniquement illustratif et nullement limitatif de la portée de l'invention et à partir de l'illustration suivante dans laquelle la figure 1 est une vue schématique en coupe axiale d'un mode de réalisation possible d'un poste de traitement approprié pour la mise en oeuvre du procédé selon l'invention.

L'invention est dans ce qui suit décrite dans le cadre du traitement de récipients en matière plastique, et plus précisément sous la forme d'un dispositif et d'un procédé permettant le revêtement de la face interne d'un récipient en matière plastique, tel qu'une bouteille.

Le poste 10 de traitement peut par exemple faire partie d'une machine rotative comportant un carrousel animé d'un mouvement continu de rotation autour d'un axe vertical.

Le poste 10 de traitement comporte une enceinte 14 réalisée en matériau conducteur de l'électricité et formée d'une paroi cylindrique tubulaire 18 d'axe A1 vertical. L'enceinte 14 est fermée à son extrémité inférieure par une paroi inférieure de fond 20.

A l'extérieur de l'enceinte 14, fixé à celle-ci, on trouve un boîtier 22 qui comporte des moyens (non représentés) pour créer à l'intérieur de l'enceinte 14 un champ électromagnétique apte à générer un plasma et qui sont notamment aptes à générer un rayonnement électromagnétique dans le domaine UHF, c'est-à-dire dans le domaine des microondes. Dans ce cas, le boîtier 22 peut donc renfermer un magnétron dont l'antenne 24 débouche dans un guide d'onde 26 se présentant, par exemple, sous la forme d'un tunnel de section rectangulaire qui débouche directement à l'intérieur de l'enceinte 14, au travers de la paroi latérale 18. Toutefois, l'invention pourrait aussi être mise en oeuvre dans le cadre d'un dispositif muni d'une source de rayonnement de type radiofréquence, et/ou la source pourrait aussi être agencée différemment, par exemple à l'extrémité axiale inférieure de l'enceinte 14.

A l'intérieur de l'enceinte 14, on trouve un tube 28 d'axe A1 qui est réalisé avec un matériau transparent, par exemple en quartz, pour les ondes électromagnétiques introduites dans l'enceinte 14 via le guide d'onde 26. Ce tube 28 est destiné à recevoir un récipient à traiter et délimite une cavité 32 dans laquelle il sera créé une dépression une fois le récipient à l'intérieur de l'enceinte.

L'enceinte 14 est partiellement refermée à son extrémité supérieure par une paroi supérieure 36 qui est pourvue d'une ouverture centrale de telle sorte que le tube 28 soit totalement ouvert vers le haut pour permettre l'introduction du récipient 30 dans la cavité 32.

Pour refermer l'enceinte 14 et la cavité 32, le poste 10 de traitement comporte un couvercle 34 qui est mobile axialement entre une position haute (non représentée) et une position basse de fermeture étanche illustrée à la figure 1 où le couvercle 34 vient en appui de manière étanche contre la face supérieure de la paroi supérieure 36 de l'enceinte 14.

Le couvercle 34 porte des moyens 54 de support du récipient de type connu en soi, sous la forme d'une cloche à griffes qui vient s'engager ou s'encliqueter autour du col, de préférence sous la collerette du récipient (les récipients étant préférentiellement des bouteilles en matériau thermoplastique, par exemple en polyéthylène téréphtalate (PET) et comportent une collerette en excroissance radiale à la base de leur col).

Le traitement interne du récipient impose de pouvoir contrôler à la fois la pression et la composition des gaz présents à l'intérieur du récipient. Pour cela, l'intérieur du récipient doit pouvoir être mis en communication avec une source de dépression et avec un dispositif d'alimentation en fluide réactionnel 12. Ce dernier comporte donc une source 16 de fluide réactionnel relié par une tubulure 38 à un injecteur 62 qui est agencé selon l'axe A1 et qui est mobile par rapport au couvercle 34 entre une position haute escamotée (non représentée) et une position basse dans laquelle l'injecteur 62 est plongé à l'intérieur du récipient 30, au travers du couvercle 34. Une vanne commandée 40 est interposée dans la tubulure 38 entre la source 16 de fluide et l'injecteur 62.

Pour que le gaz injecté par l'injecteur 62 puisse être ionisé et former un plasma sous l'effet du champ électromagnétique créé dans l'enceinte, il est nécessaire que la pression dans le récipient soit inférieure à la pression atmosphérique, par exemple de l'ordre de 5x10⁻⁴ bar. Pour mettre en communication l'intérieur du récipient avec une source de dépression (par exemple une pompe), le couvercle 34 comporte un canal interne 64 dont une terminaison principale débouche dans la face inférieure du couvercle, plus précisément au centre de la surface d'appui contre laquelle est plaqué le col de bouteille 30.

Dans l'exemple illustré, le canal 64 interne du couvercle 24 comporte une extrémité de jonction 66 et le circuit de vide de la machine comporte une extrémité fixe 68 qui est disposée de telle sorte que les deux extrémités 66, 68 soient en regard l'une de l'autre lorsque le couvercle est en position de fermeture.

Le fonctionnement du dispositif qui vient d'être décrit peut donc être le suivant. Une fois le récipient chargé sur la cloche à griffes 54, le couvercle s'abaisse vers sa position de fermeture. Dans le même temps, l'injecteur s'abaisse au travers de la terminaison principale 65 du canal 64, mais sans l'obturer. Lorsque le couvercle en position de fermeture, il est possible d'aspirer l'air contenu dans la cavité 32, laquelle se trouve reliée au circuit de vide grâce au canal interne 64 du couvercle 34.

Dans un premier temps, la soupape est commandée pour être ouverte si bien que la pression chute dans la cavité 32 à la fois à l'extérieur et à l'intérieur du récipient. Lorsque le niveau de vide à l'extérieur du récipient a atteint un niveau suffisant, le système commande la fermeture de la soupape. Il est alors possible de continuer le pompage exclusivement à l'intérieur du récipient 30.

Une fois la pression de traitement atteinte, le traitement peut commencer selon le procédé de l'invention.

Dans un premier temps, on procède à l'injection dans la zone de traitement d'un mélange d'un composé organisilicé, par exemple un organosiloxane, et préférentiellement d'hexaméthyldisiloxane (HMDSO), et d'un composé azoté, de préférence l'azote gazeux (N₂), pendant un temps T1, de préférence inférieur à une seconde.

Puisque les organosiloxanes, tels que le HMDSO, le triméthydisiloxane, le triméthylsilane et le tétraméthylsiloxane (TMDSO), sont généralement liquides à température ambiante (en général aux alentours de 20-25°C), et afin de les injecter dans la zone de traitement sous forme gazeuse, il est soit utilisé un gaz porteur qui, dans un bulleur, se combine à des vapeurs de l'organosiloxane, soit travaillé à la pression de vapeur saturante de l'organosiloxane. En général, le gaz porteur est un gaz rare, tel que l'hélium ou l'argon, même si préférentiellement on utilise l'azote gazeux (N₂) comme gaz porteur.

Des microondes sont alors appliquées pendant un temps T2, ce qui permet de porter à l'état de plasma le mélange gazeux injecté, T2 correspondant au temps nécessaire pour déposer une première couche sur le substrat à traiter, à savoir un film ou la face interne d'un récipient en matière thermoplastique telle que du PET.

Préférentiellement, afin d'obtenir la première couche sur le substrat, pour une zone de traitement présentant un volume de 500 mL, le débit d'injection de l'hexaméthyldisiloxane est compris entre 4 et 12 sccm (standard centimètre cube par minute), et est préférentiellement de 5 sccm, le débit d'injection de l'azote gazeux (N₂) est compris entre 10 et 100 sccm, et est préférentiellement de 30 sccm, et la puissance microondes appliquée est comprise entre 200 et 500 W, et est préférentiellement de 350 W. Le temps de dépôt de la première couche est compris entre 0.2 et 2 secondes, ce qui permet d'obtenir une première couche dont l'épaisseur est d'environ 4 nm.

La première couche formée est ainsi composée d'atomes de silicium Si, d'atomes de carbone C, d'atomes d'oxygène O, d'atomes d'azote N et d'atomes d'hydrogène H et présente une composition chimique de formule SiOxCyHzNu, la valeur de x étant comprise entre 1 et 1,5, et préférentiellement de 1,25, la valeur de y étant comprise entre 0,5 et 2, et est préférentiellement de 1,5, la valeur de z étant comprise entre 0,5 et 2, et est préférentiellement de 0,85, et la valeur de u étant comprise entre 0,1 et 1, et est préférentiellement de 0,5.

De manière préférentielle, la composition de la première couche est d'environ 20% d'atomes de silicium, environ 25% d'atomes d'oxygène, environ 30% d'atomes de carbone, environ 10% d'atomes d'azote et environ 15% d'atomes d'hydrogène.

On soulignera que la première couche ainsi formée ne présente en elle-même aucun effet de barrière aux gaz et que sa fonction est de procurer une adhésion parfaite entre le substrat thermoplastique et la deuxième couche dont question ci-après.

Afin de former sur la première couche une deuxième couche à effet barrière, on porte à l'état de plasma un composé conduisant essentiellement à un oxyde de silicium de type SiOx. A cet effet, on injecte dans la zone de traitement, en plus du mélange comprenant au moins un composé organosilicé et un composé azoté, notamment un mélange respectivement de HMDSO et de N₂, une quantité d'oxygène pendant un temps T3.

De manière préférentielle, il est prévu d'injecter de l'azote gazeux lors de l'étape du dépôt de la seconde couche, même si l'azote n'est pas nécessaire pour l'obtention d'une couche de type SiOx.

Des microondes sont alors appliquées pendant un temps T4, ce qui correspond au temps nécessaire pour former la deuxième couche de type SiOx. En effet, l'oxygène, largement excédentaire dans le plasma lors de son injection, provoque l'élimination presque complète des atomes de carbone, d'azote et d'hydrogène qui sont apportés soit par le HMDSO, soit par l'azote.

Préférentiellement, afin d'obtenir la seconde couche barrière de type SiOx, pour une zone de traitement présentant un volume de 500 mL, le débit d'injection de l'hexaméthyldisiloxane est compris entre 4 et 12 sccm, et est préférentiellement de 5 sccm, le débit d'injection de l'azote gazeux est compris entre 10 et 100 sccm, et est préférentiellement de 30 sccm, le débit d'injection du dioxygène est compris entre 40 et 120 sccm, la puissance microondes appliquée est comprise entre 200 et 500 W, et est préférentiellement de 350 W. Le temps de dépôt pour la seconde couche est compris entre 1 et 4 secondes. De manière avantageuse, les débits en HMDSO et en N₂ ne sont donc pas modifiés entre l'étape de formation de la première couche et l'étape de formation de la seconde couche barrière, permettant une formation en continu des différentes couches sans temps d'arrêt entre les différentes étapes.

On obtient ainsi un matériau de type SiOx où x exprime le rapport de la quantité d'oxygène par rapport à la quantité de silicium et qui est généralement compris entre 1,5 et 2,2 suivant les conditions opératoires utilisées, et est préférentiellement compris entre 1,8 et 2,1. Bien entendu, des impuretés dues au mode d'obtention peuvent s'incorporer en faibles quantités dans cette couche sans en modifier de manière significative les propriétés.

La deuxième couche se présente essentiellement sous la forme d'un oxyde de silicium de type SiOx. Il a ainsi pu être constaté que la composition chimique de la deuxième couche est constituée d'environ 30% d'atomes de silicium, d'environ 63% d'atomes d'oxygène, d'environ 3% d'atomes de carbone et d'environ 4% d'atomes d'hydrogène.

Après l'arrêt d'injection d'oxygène O₂, on injecte ensuite dans la zone de traitement un mélange d'un composé organosilicé, notamment de HMDSO, et d'un composé azoté, notamment de N₂, et on applique des microondes pendant un temps T5, ce qui conduit au dépôt d'une troisième couche sur la deuxième couche barrière. Les mélanges utilisés pour la formation des première et troisième couches sont de compositions relativement proches, et préférentiellement ces mélanges sont de compositions identiques.

Préférentiellement, pour l'obtention de la troisième couche, pour une zone de traitement présentant un volume de 500 mL, le débit d'injection de l'hexaméthyldisiloxane est compris entre 4 et 12 sccm, et est préférentiellement de 5 sccm, le débit d'injection de l'azote gazeux est compris entre 10 et 100 sccm, et est préférentiellement de 30 sccm, la puissance microondes appliquée est comprise entre 200 et 500 W, et est préférentiellement de 350 W. Le temps de dépôt de la troisième couche est compris entre 0,2 et 2 secondes. De la sorte, il est obtenu une troisième couche dont l'épaisseur est d'environ 4 nm. De nouveau, on injecte préférentiellement dans la zone de traitement les mêmes débits en HMDSO et en N₂ que lors des étapes de formation des première et seconde couches.

On soulignera que la troisième couche ainsi constituée est sensiblement identique à la première couche précitée et que, comme celle-ci, elle ne présente en elle-même aucun effet de barrière aux gaz.

Le temps total pour procéder aux dépôts des trois couches selon le procédé de l'invention est compris entre 2,4 secondes et 4 secondes, ce qui permet d'atteindre des cadences de production de récipients revêtus compris entre 10 000 récipients/heure à 30 000 récipients/heure.

Préférentiellement, les vitesses de dépôt pour la première et la troisième couche sont comprises entre 6 et 12 nm/s, de préférence autour de 9 nm/s, et la vitesse de dépôt pour la deuxième couche, de type SiOx, est comprise entre 2 et 6 nm/s, et de préférence autour de 4 nm/s.

La troisième couche ainsi formée est composée d'atomes de silicium Si, d'atomes de carbone C, d'atomes d'oxygène O, d'atomes d'azote N et d'atomes d'hydrogène H. Plus précisément, de manière préférentielle, la troisième couche présente une composition chimique de formule SiOxCyHzNu, la valeur de x étant comprise entre 1 et 1,5, et est préférentiellement de 1,25, la valeur de y étant comprise entre 0,5 et 2, et est préférentiellement de 1,5, la valeur de z étant comprise entre 0,5 et 2, et est préférentiellement de 0,85, et la valeur de u étant comprise entre 0,1 et 1, et est préférentiellement de 0,5. Selon un mode de réalisation préférentiel, la troisième couche contient environ 20% d'atomes de silicium, environ 25% d'atomes d'oxygène, environ 30% d'atomes de carbone, environ 10% d'atomes d'azote et environ 15% d'atomes d'hydrogène.

Pour résumer le mode de réalisation préférentiel, le tableau ci-après indique la composition atomique des trois couches constitutives du revêtement conforme à l'invention.

| | % Si | % O | % C | % N | % H |
|---|---|---|---|---|---|
| 1^{ère} couche | 20 | 25 | 30 | 10 | 15 |
| 2^{ème} couche | 30 | 63 | 3 | 0 | 4 |
| 3^{ème} couche | 20 | 25 | 30 | 10 | 15 |

Bien que, de manière préférentielle, la première couche et la troisième couche soient sensiblement identiques et présentent toutes deux une épaisseur inférieure à 20 nm, et préférentiellement de 4 nm, il est également possible que la première couche soit différente de la troisième couche en terme de composition chimique, même si les première et troisième couches sont toujours composées d'atomes de silicium Si, d'atomes de carbone C, d'atomes d'oxygène O, d'atomes d'azote N et d'atomes d'hydrogène H.

Par ailleurs, il convient de noter que les différentes couches formées sur le substrat, et plus particulièrement les différentes couches formées à l'intérieur du récipient peuvent comporter d'autres éléments (à savoir d'autres éléments que le Si, C, O, H et N pour les première et troisième couches et Si et O pour la deuxième couche) en quantités faibles ou à l'état de trace, ces autres composants provenant alors d'impuretés contenues dans les fluides réactionnels utilisés ou tout simplement d'impuretés dues à la présence d'air résiduel encore présent en fin de pompage.

Après arrêt des microondes et arrêt de l'injection d'un mélange gazeux, le récipient est ensuite remis à la pression atmosphérique.

De manière préférentielle, la source 16 réactionnelle, telle que représentée schématiquement sur la figure 1, est constituée d'une première source gazeuse contenant un mélange d'un composé organosilicé, notamment de HMDSO, et d'un composé azoté, notamment d'azote N₂, et d'une seconde source gazeuse contenant de l'oxygène O₂.

Les différentes étapes pour la mise en oeuvre du procédé selon l'invention peuvent être réalisées sous la forme d'étapes parfaitement séparées ou, au contraire, sous la forme de plusieurs étapes enchaînées, sans que le plasma ne s'éteigne entre les deux.

Le revêtement barrière ainsi obtenu se révèle particulièrement performant quant au taux de perméabilité à l'oxygène. Ainsi, une bouteille standard en PET (polyéthylène téréphtalate) de 500 ml sur laquelle il n'a pas été déposé de couches barrières présente un taux de perméabilité de 0,04 centimètre cube d'oxygène entrant dans la bouteille par jour.

Après application d'un revêtement à trois couches selon le procédé de l'invention, le taux de perméabilité est de 0,001 centimètre cube d'oxygène entrant dans la bouteille par jour mesuré à 1 bar, soit une amélioration d'un facteur 40 de la valeur du taux de perméabilité à l'oxygène par rapport à un récipient en PET selon l'art antérieur non revêtu.

Le procédé selon l'invention permet donc d'obtenir un facteur d'amélioration de la barrière à l'oxygène pour un récipient au moins égal à 40 fois.

En d'autres termes, la Demanderesse a pu constater, sans cependant pouvoir l'expliquer, que, de façon surprenante, bien que les première et troisième couches ne présentent individuellement aucun effet barrière vis-à-vis des gaz, l'ensemble des première, deuxième et troisième couches constituant le revêtement conforme à l'invention présentait un effet barrière aux gaz qui était supérieur à celui procuré par les seules première et deuxième couches des revêtements antérieurs.

Par ailleurs, il convient de noter, qu'afin de renforcer l'effet barrière et l'imperméabilité à l'oxygène, il est possible de prévoir une quatrième couche, déposée sur la troisième couche, composée essentiellement d'un oxyde de silicium de formule SiOx ainsi qu'une cinquième couche, déposée sur la quatrième couche, composée essentiellement de silicium, de carbone, d'oxygène, d'azote et d'hydrogène.

Dans ce cas, la quatrième couche peut avoir sensiblement la même composition chimique que la deuxième couche et peut être obtenue dans des conditions similaires de débits et de mélange gazeux injecté tandis que la cinquième couche peut avoir sensiblement la même composition chimique que les première et troisième couches et peut être obtenue dans des conditions similaires de débits et de mélange gazeux injecté.

De manière générale, il est ainsi possible de prévoir de déposer une alternance de (2n+1) couches barrières sur le substrat (et préférentiellement sur la face interne d'une bouteille), n étant un nombre entier supérieur ou égal à 1, avec les première, troisième, ...., (2n+1)-ième couches composées essentiellement de silicium, de carbone, d'oxygène, d'azote et d'hydrogène, tandis que les deuxième, quatrième, ...., (2n)-ième couches sont composées essentiellement d'un oxyde de silicium de formule SiOx.

La Demanderesse a ainsi pu constater qu'en multipliant le nombre d'interfaces du type SiOxCyHzNu/SiOx, il apparaît une amélioration très nette de l'effet barrière, tout en bénéficiant d'une meilleure maitrise du procédé de dépôt, d'où une facilité de mise en oeuvre d'un point de vue industriel.

## Revendications

1. Procédé mettant en oeuvre un plasma à faible pression pour déposer un revêtement barrière vis-à-vis des gaz sur un substrat thermoplastique, dans lequel le plasma est obtenu par ionisation partielle, sous l'action d'un champ électromagnétique, d'un fluide réactionnel injecté sous faible pression dans une zone de traitement, ce procédé comportant :
- au moins une première étape consistant à déposer, sur le substrat thermoplastique, une première couche, ou couche d'adhésion, qui est obtenue en portant à l'état de plasma un mélange comprenant au moins un composé organosilicé et un autre composé,
- au moins une deuxième étape consistant à déposer, sur ladite première couche, une deuxième couche, ou couche à effet barrière, qui est obtenue en portant à l'état de plasma un composé conduisant essentiellement à un oxyde de silicium de formule SiOx, laquelle deuxième couche présente un effet barrière vis-à-vis des gaz, et
- au moins une troisième étape consistant à déposer, sur ladite deuxième couche, une troisième couche qui est obtenue en portant à l'état de plasma un mélange comprenant au moins un composé organosilicé et un autre composé,
- les mélanges utilisés pour la formation des première et troisième couches étant de compositions au moins relativement proches,
**caractérisé en ce que** lesdits autres composés sont tous deux des composés azotés,
ce grâce à quoi, bien que les première et troisième couches ne présentent individuellement aucun effet barrière vis-à-vis des gaz, l'ensemble des première, deuxième et troisième couches présente un effet barrière vis-à-vis des gaz qui est supérieur à celui procuré par les seules première et deuxième couches.

2. Procédé selon la revendication 1, **caractérisé en ce que** lesdits mélanges utilisés pour la formation des première et troisième couches respectivement sont de compositions identiques et comprennent le même composé azoté.

3. Procédé selon la revendication 1 ou 2, **caractérisé en ce que** le composé azoté est de l'azote gazeux.

4. Procédé selon l'une quelconque des revendications 1 à 3, **caractérisé en ce que** l'étape consistant à déposer une deuxième couche composée essentiellement d'un oxyde de silicium de formule SiOx est obtenue en portant à l'état de plasma un mélange comportant au moins un composé organosilicé, un composé azoté et de l'oxygène.

5. Procédé selon l'une quelconque des revendications 1 à 4, **caractérisé en ce que** le composé organosilicé est un organosiloxane, préférentiellement de l'hexaméthyldisiloxane, du triméthyldisiloxane ou du triméthylsilane.

6. Procédé selon l'une quelconque des revendications 1 à 5, **caractérisé en ce que** les étapes s'enchaînent en continu de telle sorte que, dans la zone de traitement, le fluide réactionnel demeure à l'état de plasma lors des transitions des différentes étapes.

7. Procédé selon les revendications 3 et 4, **caractérisé en ce que**, pour une zone de traitement présentant un volume de 500 ml,
le composé organosilicé est l'hexaméthyldisiloxane avec un débit d'injection compris entre 4 et 12 sccm, préférentiellement de 5 sccm,
l'azote gazeux a un débit d'injection compris entre 10 et 100 sccm, préférentiellement de 30 sccm,
l'oxygène a un débit d'injection compris entre 40 et 120 sccm, et
la puissance microondes appliquée est comprise entre 200 et 500 W, préférentiellement de 350 W.

8. Procédé selon l'une quelconque des revendications 1 à 7, **caractérisé en ce que** le temps de dépôt de la première couche est compris entre 0,2 et 2 secondes, **en ce que** le temps de dépôt de la deuxième couche est compris entre 1 et 4 secondes et **en ce que** le temps de dépôt de la troisième couche est compris entre 0,2 et 2 secondes, le temps total du procédé étant compris entre 2,4 et 4 secondes.

9. Revêtement barrière déposé sur un substrat thermoplastique par plasma à basse pression, comportant :
- une première couche, ou couche d'adhésion, déposée sur le substrat, constituée d'un composé comprenant au moins du silicium, du carbone, de l'oxygène et de l'hydrogène,
- une deuxième couche, ou couche à effet barrière, déposée sur ladite première couche, composée essentiellement d'un oxyde de silicium de formule SiOx, et
- une troisième couche déposée sur ladite deuxième couche, constituée d'un composé comprenant au moins du silicium, du carbone, de l'oxygène et de l'hydrogène,
- les première et troisième couches ayant des compositions chimiques sensiblement voisines,
**caractérisé en ce que** lesdits composés constitutifs desdites première et troisième couches comprennent tous deux en outre de l'azote,
ce grâce à quoi, bien que les première et troisième couches ne présentent individuellement aucun effet barrière vis-à-vis des gaz, l'ensemble des première, deuxième et troisième couches présente un effet barrière vis-à-vis des gaz qui est supérieur à celui procuré par les seules première et deuxième couches.

10. Revêtement selon la revendication 9, **caractérisé en ce que** l'épaisseur des première et troisième couches est inférieure à 20 nm, et de manière préférentielle est d'environ 4 nm.

11. Revêtement selon la revendication 9 ou 10, **caractérisé en ce que** la première couche et la troisième couche ont sensiblement la même composition chimique.

12. Revêtement selon l'une quelconque des revendications 9 à 11, **caractérisé en ce que** la deuxième couche est composé essentiellement d'un oxyde de silicium de formule SiOx avec x compris entre 1,8 et 2,1.

13. Revêtement selon l'une quelconque des revendications 9 à 12, **caractérisé en ce que** la première couche et/ou la troisième couche présentent une composition chimique de formule SiOxCyHzNu, la valeur de x étant comprise entre 1 et 1,5, préférentiellement de 1,25, la valeur de y étant comprise entre 0,5 et 2, préférentiellement de 1,5, la valeur de z étant comprise entre 0,5 et 2, préférentiellement de 0,85, et la valeur de u étant comprise entre 0,1 et 1, préférentiellement de 0,5.

14. Revêtement selon l'une quelconque des revendications 9 à 13, **caractérisé en ce qu'**il comprend une quatrième couche, déposée sur la troisième couche, composée essentiellement d'un oxyde de silicium de formule SiOx ainsi qu'une cinquième couche, déposée sur la quatrième couche, composée essentiellement de silicium, de carbone, d'oxygène, d'azote et d'hydrogène.

15. Récipient en matière polymère, **caractérisé en ce qu'**il est recouvert, sur au moins une de ses faces, d'un revêtement barrière selon l'une quelconque des revendications 9 à 14.

16. Récipient selon la revendication 15, **caractérisé en ce qu'**il est revêtu d'un revêtement barrière sur sa face interne.

17. Récipient selon la revendication 15 ou 16, **caractérisé en ce qu'**il s'agit d'une bouteille en polyéthylène téréphtalate.

## Patentansprüche

1. Verfahren zur Anwendung eines Niederdruckplasmas, um eine Sperrbeschichtung gegen Gase auf einem thermoplastischen Substrat abzulagern, wobei das Plasma durch teilweise Ionisierung eines Reaktionsmediums, das unter geringem Druck in einen Behandlungsbereich eingespritzt wird, unter der Wirkung eines elektromagnetischen Felds erhalten wird, wobei das Verfahren Folgendes beinhaltet:
- zumindest einen ersten Schritt, der darin besteht, auf dem thermoplastischen Substrat eine erste Schicht bzw. Haftschicht abzulagern, die erhalten wird, indem ein Gemisch, das zumindest eine Organosiliciumverbindung und eine andere Verbindung umfasst, in den Plasmazustand gebracht wird,
- zumindest einen zweiten Schritt, der darin besteht, auf der ersten Schicht eine zweite Schicht bzw. Schicht mit Sperrwirkung abzulagern, die erhalten wird, indem eine Verbindung, die im Wesentlichen zu einem Siliciumoxid der Formel SiOx führt, in den Plasmazustand gebracht wird, wobei die zweite Schicht eine Sperrwirkung gegen Gase aufweist, und
- zumindest einen dritten Schritt, der darin besteht, auf der zweiten Schicht eine dritte Schicht abzulagern, die erhalten wird, indem ein Gemisch, das zumindest eine Organosiliciumverbindung und eine andere Verbindung umfasst, in den Plasmazustand gebracht wird,
- wobei die zur Ausbildung der ersten und dritten Schicht verwendeten Gemische von Zusammensetzungen sind, die einander zumindest relativ ähneln,
**dadurch gekennzeichnet, dass** die anderen Verbindungen beide Stickstoffverbindungen sind, wodurch, wenngleich die erste und dritte Schicht einzeln keinerlei Sperrwirkung gegen Gase aufweisen, die erste, zweite und dritte Schicht im Ganzen eine Sperrwirkung gegen Gase aufweisen, die höher ist als die, welche allein durch die erste und zweite Schicht erreicht wird.

2. Verfahren nach Anspruch 1, **dadurch gekennzeichnet, dass** die jeweils zur Ausbildung der ersten und dritten Schicht verwendeten Gemische von identischen Zusammensetzungen sind und dieselbe Stickstoffverbindung umfassen.

3. Verfahren nach Anspruch 1 der 2, **dadurch gekennzeichnet, dass** die Stickstoffverbindung gasförmiger Stickstoff ist.

4. Verfahren nach einem der Ansprüche 1 bis 3, **dadurch gekennzeichnet, dass** der Schritt, welcher darin besteht, eine zweite Schicht, die im Wesentlichen aus einem Siliciumoxid der Formel SiOx zusammengesetzt ist, abzulagern, erhalten wird, indem ein Gemisch, das zumindest eine Organosiliciumverbindung, eine Stickstoffverbindung und Sauerstoff beinhaltet, in den Plasmazustand gebracht wird.

5. Verfahren nach einem der Ansprüche 1 bis 4, **dadurch gekennzeichnet, dass** die Organosiliciumverbindung ein Organosiloxan, vorzugsweise Hexamethyldisiloxan, Trimethyldisiloxan oder Trimethylsilan, ist.

6. Verfahren nach einem der Ansprüche 1 bis 5, **dadurch gekennzeichnet, dass** die Schritte kontinuierlich aufeinanderfolgen, sodass das Reaktionsmedium im Behandlungsbereich während der Übergänge zwischen den verschiedenen Schritten im Plasmazustand bleibt.

7. Verfahren nach Anspruch 3 und 4, **dadurch gekennzeichnet, dass** für einen Behandlungsbereich mit einem Volumen von 500 ml
die Organosiliciumverbindung Hexamethyldisiloxan mit einem Einspritzdurchsatz von 4 bis 12 sccm, vorzugsweise 5 sccm, ist,
der gasförmige Stickstoff einen Einspritzdurchsatz von 10 bis 100 sccm, vorzugsweise 30 sccm, aufweist,
der Sauerstoff einen Einspritzdurchsatz von 40 bis 120 sccm aufweist und
die angewandte Mikrowellenleistung 200 bis 500 W, vorzugsweise 350 W, beträgt.

8. Verfahren nach einem der Ansprüche 1 bis 7, **dadurch gekennzeichnet, dass** die Ablagerungsdauer der ersten Schicht 0,2 bis 2 Sekunden beträgt, dass die Ablagerungsdauer der zweiten Schicht 1 bis 4 Sekunden beträgt und dass die Ablagerungsdauer der dritten Schicht 0,2 bis 2 Sekunden beträgt, wobei die Gesamtdauer des Verfahrens 2,4 bis 4 Sekunden beträgt.

9. Sperrbeschichtung, die durch Niederdruckplasma auf einem thermoplastischen Substrat abgelagert wird, beinhaltend:
- eine erste Schicht bzw. Haftschicht, die auf dem Substrat abgelagert wird und aus einer Verbindung besteht, die zumindest Silicium, Kohlenstoff, Sauerstoff und Wasserstoff umfasst,
- eine zweite Schicht bzw. Schicht mit Sperrwirkung, die auf der ersten Schicht abgelagert wird und im Wesentlichen aus einem Siliciumoxid der Formel SiOx besteht, und
- eine dritte Schicht, die auf der zweiten Schicht abgelagert wird und aus einer Verbindung besteht, die zumindest Silicium, Kohlenstoff, Sauerstoff und Wasserstoff umfasst,
- wobei die erste und dritte Schicht im Wesentlichen ähnliche chemische Zusammensetzungen aufweisen,
**dadurch gekennzeichnet, dass** die Verbindungen, welche die erste und dritte Schicht ausbilden, beide ferner Stickstoff beinhalten,
wodurch, wenngleich die erste und dritte Schicht einzeln keinerlei Sperrwirkung gegen Gase aufweisen, die erste, zweite und dritte Schicht im Ganzen eine Sperrwirkung gegen Gase aufweisen, die höher ist als die, welche allein durch die erste und zweite Schicht erreicht wird.

10. Beschichtung nach Anspruch 9, **dadurch gekennzeichnet, dass** die Stärke der ersten und dritten Schicht weniger als 20 nm und vorzugsweise etwa 4 nm beträgt.

11. Beschichtung nach Anspruch 9 oder 10, **dadurch gekennzeichnet, dass** die erste Schicht und die dritte Schicht im Wesentlichen dieselbe chemische Zusammensetzung aufweisen.

12. Beschichtung nach einem der Ansprüche 9 bis 11, **dadurch gekennzeichnet, dass** die zweite Schicht im Wesentlichen aus einem Siliciumoxid der Formel SiOx zusammengesetzt ist, wobei x 1,8 bis 2,1 beträgt.

13. Beschichtung nach einem der Ansprüche 9 bis 12, **dadurch gekennzeichnet, dass** die erste Schicht und/oder die dritte Schicht eine chemische Zusammensetzung der Formel SiOxCyHzNu aufweisen, wobei der Wert x 1 bis 1,5, vorzugsweise 1,25, beträgt, der Wert y 0,5 bis 2, vorzugsweise 1,5, beträgt, der Wert z 0,5 bis 2, vorzugsweise 0,85, beträgt und der Wert u 0,1 bis 1, vorzugsweise 0,5, beträgt.

14. Beschichtung nach einem der Ansprüche 9 bis 13, **dadurch gekennzeichnet, dass** sie eine vierte Schicht, die auf der dritten Schicht abgelagert wird und im Wesentlichen aus einem Siliciumoxid der Formel SiOx zusammengesetzt ist, sowie eine fünfte Schicht, die auf der vierten Schicht abgelagert wird und im Wesentlichen aus Silicium, Kohlenstoff, Sauerstoff, Stickstoff und Wasserstoff zusammengesetzt ist, umfasst.

15. Behälter aus Polymermaterial, **dadurch gekennzeichnet, dass** er auf zumindest einer seiner Seiten mit einer Sperrbeschichtung nach einem der Ansprüche 9 bis 14 bedeckt ist.

16. Behälter nach Anspruch 15, **dadurch gekennzeichnet, dass** er auf seiner Innenseite mit einer Sperrbeschichtung beschichtet ist.

17. Behälter nach Anspruch 15 oder 16, **dadurch gekennzeichnet, dass** es sich um eine Flasche aus Polyethylenterphtalat handelt.

## Claims

1. Method implementing a low-pressure plasma to deposit a barrier coating vis-à-vis gases on a thermoplastic substrate, in which the plasma is obtained by partial ionisation, under the influence of an electromagnetic field, of a reaction fluid injected at low pressure into a treatment zone, such method comprising:
- at least a first step consisting of depositing, on the thermoplastic substrate, a first layer, or adhesion layer, which is obtained by bringing to the plasma state a mixture comprising at least one organosilicon compound and another compound,
- at least a second step consisting of depositing, on said first layer, a second layer, or barrier effect layer, which is obtained by bringing to the plasma state a compound leading essentially to a silicon oxide with the formula SiOx, which second layer has a barrier effect vis-à-vis gases, and
- at least a third step consisting of depositing, on said second layer, a third layer, which is obtained by bringing to the plasma state a mixture comprising at least one organosilicon compound and another compound,
- the mixtures used for the formation of the first and third layers having at least relatively similar compositions,
**characterised in that** said other compounds are both nitrogenous compounds,
as a result of which, although the first and third layers do not individually have any barrier effect vis-à-vis gases, the first, second and third layers as a whole have a barrier effect vis-à-vis gases that is greater than the effect provided by the first and second layers alone.

2. Method according to claim 1, **characterised in that** said mixtures used for the formation of the first and third layers respectively have identical compositions and comprise the same nitrogenous compound.

3. Method according to claim 1 or 2, **characterised in that** the nitrogenous compound is nitrogen gas.

4. Method according to any one of claims 1 to 3, **characterised in that** the step consisting of depositing a second layer composed essentially of a silicon oxide with the formula SiOx is obtained by bringing to the plasma state a mixture comprising at least one organosilicon compound, a nitrogenous compound and oxygen.

5. Method according to any one of claims 1 to 4, **characterised in that** the organosilicon compound is an organosiloxane, preferably hexamethyldisiloxane, trimethyldisiloxane or trimethylsilane.

6. Method according to any one of claims 1 to 5, **characterised in that** the steps are linked continuously in such a way that, in the treatment zone, the reaction fluid remains in the plasma state during the transitions between the different steps.

7. Method according to claims 3 and 4, **characterised in that**, for a treatment zone with a volume of 500 mL,
the organosilicon compound is hexamethyldisiloxane with an injection rate of between 4 and 12 sccm, preferably 5 sccm,
the nitrogen gas has an injection rate of between 10 and 100 sccm, preferably 30 sccm,
the oxygen has an injection rate of between 40 and 120 sccm, and
the microwave power applied is between 200 and 500 W, preferably 350 W.

8. Method according to any one of claims 1 to 7, **characterised in that** the deposition time of the first layer is between 0.2 and 2 seconds, **in that** the deposition time of the second layer is between 1 and 4 seconds and **in that** the deposition time of the third layer is between 0.2 and 2 seconds, the total time of the method being between 2.4 and 4 seconds.

9. Barrier coating deposited on a thermoplastic substrate by low-pressure plasma, comprising:
- a first layer, or adhesion layer, deposited on the substrate, constituted by a compound comprising at least silicon, carbon, oxygen and hydrogen,
- a second layer, or barrier effect layer, deposited on said first layer, composed essentially of a silicon oxide with the formula SiOx, and
- a third layer deposited on said second layer, constituted by a compound comprising at least silicon, carbon, oxygen and hydrogen,
- the first and third layers having substantially similar chemical compositions, **characterised in that** said compounds forming said first and third layers both also comprise nitrogen,
as a result of which, although the first and third layers do not individually have any barrier effect vis-à-vis gases, the first, second and third layers as a whole have a barrier effect vis-à-vis gases that is greater than the effect provided by the first and second layers alone.

10. Coating according to claim 9, **characterised in that** the thickness of the first and third layers is less than 20 nm, and is preferably approximately 4 nm.

11. Coating according to claim 9 or 10, **characterised in that** the first layer and the third layer have substantially the same chemical composition.

12. Coating according to any one of claims 9 to 11, **characterised in that** the second layer is essentially composed of a silicon oxide with the formula SiOx, where x is between 1.8 and 2.1.

13. Coating according to any one of claims 9 to 12, **characterised in that** the first layer and/or the third layer has a chemical composition with the formula SiOxCyHzNu, the value of x being between 1 and 1.5, preferably 1.25, the value of y being between 0.5 and 2, preferably 1.5, the value of z being between 0.5 and 2, preferably 0.85, and the value of u being between 0.1 and 1, preferably 0.5.

14. Coating according to any one of claims 9 to 13, **characterised in that** it comprises a fourth layer, deposited on the third layer, composed essentially of a silicon oxide with the formula SiOx, together with a fifth layer, deposited on the fourth layer, composed essentially of silicon, carbon, oxygen, nitrogen and hydrogen.

15. Container made from a polymer material, **characterised in that** it is covered, on at least one of its surfaces, with a barrier coating according to any one of claims 9 to 14.

16. Container according to claim 15, **characterised in that** it is coated with a barrier coating on its inner surface.

17. Container according to claim 15 or 16, **characterised in that** it is a bottle made of polyethylene terephthalate.
